# FASCICULE DE BREVET EUROPEEN

(11) **EP 3 670 438 B1**
(45) Date de publication et mention de la délivrance du brevet: **23.03.2022**
(21) Numéro de dépôt: 19215918.4
(22) Date de dépôt: 13.12.2019
(51) Int. Cl.: B81B 3/00, G01C 19/5621, G01P 15/08, G02B 26/08, H04R 19/00, G01C 19/56

(54) **ARTICULATION HORS-PLAN POUR SYSTÈMES MICRO ET NANOÉLECTROMÉCANIQUES À NON-LINÉARITE RÉDUITE**
GELENK AUSSERHALB DER EBENE FÜR MIKRO- UND NANOELEKTROMECHANISCHE SYSTEME MIT REDUZIERTER NICHTLINEARITÄT
OUT-OF-PLANE JOINT FOR MICRO- AND NANO-ELECTROMECHANICAL SYSTEMS WITH REDUCED NON-LINEARITY

(30) Priorité: 20.12.2018 FR 1873564
(43) Date de publication de la demande: 24.06.2020
(73) Titulaire: Commissariat à l'énergie atomique et aux énergies alternatives, 75015 Paris (FR)
(72) Inventeur: DAGHER, Samer, 38054 GRENOBLE CEDEX 09 (FR); JOET, Loïc, 38054 GRENOBLE CEDEX 09 (FR)
(74) Mandataire: Brevalex

(56) Documents cités:
- US-A1- 2015 033 860

## Description

### DOMAINE TECHNIQUE ET ÉTAT DE LA TECHNIQUE ANTÉRIEURE

La présente invention se rapporte à une articulation hors-plan pour systèmes microélectromécaniques et/ou nanoélectromécaniques offrant une non-linéarité réduite et à un système mettant en œuvre au moins deux telles articulations.

Les systèmes microélectromécaniques ou MEMS (microelectromechanical systems en terminologie anglo-saxonne) et les systèmes micro et nanoélectromécaniques ou systèmes M&NEMS (micro & nanoelectromechanical systems en terminologie anglo-saxonne) sont utilisés pour réaliser des capteurs ou des actionneurs. Ils comportent au moins un élément mobile par rapport à un substrat. Par exemple dans le cas d'un capteur, le déplacement de la partie mobile ou masse est mesurée et peut être traduit en une caractéristique à détecter, par exemples une accélération, et dans le cas d'un actionneur, l'élément mobile est déplacé par exemple au moyen de forces électrostatiques, par exemple pour déplacer un micromiroir.

L'élément mobile est suspendu par rapport au substrat et suivant les applications on peut souhaiter qu'il ait un déplacement dans le plan du système ou un déplacement hors-plan, i.e. orthogonalement au plan du système.

Lorsque l'élément mobile a un déplacement de grande amplitude dans la direction hors-plan, la zone de liaison peut présenter une non-linéarité importante.

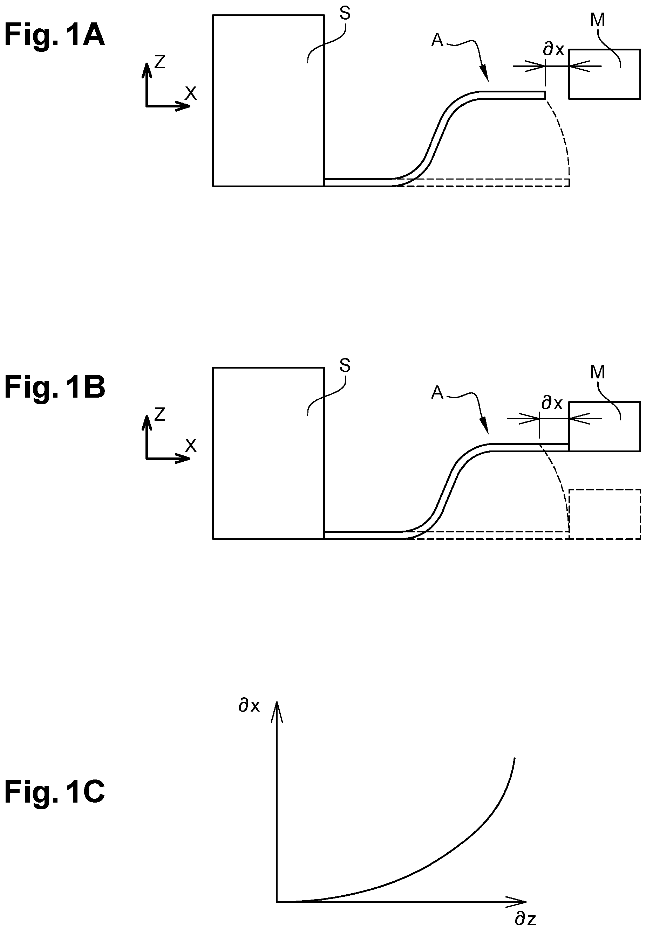

Ce comportement non-linéaire est illustré sur les figures 1A à 1C. La masse mobile M est suspendue au substrat S par une articulation A formée par une membrane fine. Le déplacement dans la direction Z de la masse M provoque une déformation de la membrane au premier ordre dans la direction Z et au second ordre dans la direction X. Lorsque le déplacement de la masse dans la direction Z est important, l'allongement de la membrane dans la direction X (figure 1B) n'est plus négligeable. Il en résulte que la force de rappel exercée par la membrane sur la masse est non linéaire (figure 1C) et varie de manière importante avec le déplacement dans la direction Z. Cette non-linéarité peut affecter sensiblement la réponse du système, par exemple dans le cas d'un capteur, et peut rendre celui-ci peu fiable.

Le document US 2015/033860 A1 de l'art antérieur décrit une articulation entre au moins un premier élément et au moins un deuxième élément d'un système microélectromécanique, ledit premier élément et ledit deuxième élément étant mobiles l'un par rapport à l'autre au moins dans une direction hors-plan, ladite articulation comportant une deuxième partie destinée à être ancrée sur le premier élément, ladite deuxième partie étant configurée pour se déformer en flexion dans une première direction, et deux troisièmes parties destinées à être ancrées sur le deuxième élément, les troisièmes parties étant configurées pour se déformer en flexion le long d'une deuxième direction orthogonale à la première direction.

### EXPOSÉ DE L'INVENTION

C'est par conséquent un but de la présente invention d'offrir une articulation pour système MEMS ou M&NEMS apte à présenter une faible non-linéarité et un système MEMS ou M&NEMS dont la partie mobile peut avoir un déplacement en translation hors-plan important tout en présentant une faible non-linéarité.

Le but énoncé ci-dessus est atteint par une articulation destinée à relier un premier élément et un deuxième élément d'un système MEMS ou M&NEMS, comportant une première partie rigide dans les trois directions de l'espace, une deuxième partie reliée à la première partie et destinée à être reliée au premier élément, la deuxième partie étant fine et destinée à s'étendre dans le plan du système, et apte à être déformée en flexion dans la direction hors-plan, et deux troisièmes parties configurées pour se déformer en flexion dans le plan, les deux troisièmes parties étant reliées chacune à une extrémité de la première partie de sorte que, lorsqu'il y a un déplacement relatif entre le premier et le deuxième élément dans la première direction, la première partie se déforme en flexion dans la direction hors-plan et les deux troisièmes parties se déforment en flexion selon une direction du plan. Les troisièmes parties offrent alors un allongement dans le plan permettant de limiter la déformation de la première partie dans le plan, et donc réduit la non-linéarité de l'articulation.

Grâce à l'invention, la déformation dans le plan de la première partie est réduite, voire évitée par les mises en légères flexion des troisièmes parties qui accompagnent la première partie dans son déplacement dans le plan.

En d'autres termes, on réalise une articulation composite comportant plusieurs parties qui assurent chacune une fonction et qui permet de réduire la non-linéarité de l'articulation. L'articulation combine à la fois une articulation obtenue par un élément sollicité en flexion dans la direction hors-plan et une articulation obtenue par des éléments configurés à se déformer en flexion selon une direction dans le plan, ce qui permet d'offrir la possibilité d'un déplacement de grande amplitude dans la direction hors-plan en conservant un faible degré de non-linéarité.

De manière très avantageuse, chaque partie peut être conçue pour adapter les propriétés de l'articulation en fonction des besoins, par exemple on peut faire varier la souplesse dans la direction hors-plan et/ou améliorer le guidage dans une direction donnée.

De manière avantageuse, un système MEMS ou M&NEMS comporte au moins deux articulations ce qui assure un très bon guidage dans la direction hors-plan et au moins un guidage dans une direction dans le plan.

Très avantageusement, le système MEMS ou M&NEMS comporte au moins trois articulations, et encore plus avantageusement quatre articulations, permettant d'assurer un guidage dans la direction hors-plan et un très bon maintien dans les deux directions du plan.

La présente invention a alors pour objet une articulation entre au moins un premier élément et au moins un deuxième élément d'un système microélectromécanique, ledit premier élément et ledit deuxième élément étant mobiles l'un par rapport à l'autre au moins dans une direction hors-plan, ladite articulation comportant une première partie rigide, une deuxième partie solidaire de la première partie par une extrémité et destinée à être ancrée au premier élément, ladite deuxième partie étant configurée pour être déformable en flexion dans une première direction, et deux troisièmes parties solidaires de la première partie et destinées à être ancrées sur le deuxième élément, les troisièmes parties étant configurées pour se déformer en flexion le long d'une deuxième direction orthogonal à la première direction.

Dans un exemple avantageux, dans un état non déformé, les troisièmes parties s'étendent dans un plan orthogonal à un plan dans lequel s'étend la deuxième partie.

De préférence, la deuxième partie présente une dimension dans la première direction réduite par rapport aux dimensions dans les autres directions.

Par exemple, la première partie s'étend, dans la première direction, entre un premier plan et un deuxième plan et la deuxième partie comporte une face située dans l'un des premier et deuxième plans.

De manière préférée, les troisièmes parties comportent au moins deux lames, s'étendant sur une partie au moins de la dimension de la première partie dans la première direction, par exemple sur toute la dimension de la première partie dans la première direction

Dans un exemple de réalisation chaque troisième partie comporte une lame, les deux lames étant coplanaires et étant disposées de sorte à également se déformer en torsion. L'articulation est alors plus souple dans la direction hors-plan.

Dans un autre exemple de réalisation, chaque troisième partie comporte deux lames, une lame de chaque troisième partie étant coplanaire avec une lame de l'autre troisième partie et les deux lames d'une troisième partie sont disposées l'une par rapport de sorte à ne pas ou peu se déformer en torsion. Les lames permettent d'obtenir la linéarité de l'articulation sans peu ou pas modifier la raideur hors-plan de l'articulation.

Les deuxièmes parties peuvent avantageusement comporter une structure en treillis de sorte à assurer une souplesse dans la première direction et une certaine rigidité dans au moins une troisième direction orthogonale aux première et deuxième directions.

Par exemple, la deuxième partie a une épaisseur dans la première direction comprise entre une centaine de nm et quelques microns, une longueur dans la troisième direction et une largeur dans la deuxième direction comprises entre quelques µm et quelques centaines de µm.

Par exemple, les troisièmes parties ont une épaisseur dans la première direction comprise entre 10 µm et quelques dizaines de µm, une largeur dans la deuxième direction du plan comprise entre 100 nm et quelques micromètres et une longueur dans la troisième direction comprise entre quelques µm et quelques dizaines de µm.

Par exemple, la première partie a une épaisseur dans la première direction, une longueur dans la troisième direction et une largeur dans la deuxième direction comprises entre quelques µm et quelques centaines de µm.

La présente invention a également pour objet un système microélectromécanique comportant un premier élément et au moins un deuxième élément mobiles l'un par rapport à l'autre au moins dans une direction hors-plan, et au moins deux articulations selon l'invention, chacune ancrées au premier élément et au deuxième élément, et les articulations sont orientées de sorte que la première direction soit la direction hors-plan et les deuxième et troisième directions soient les directions dans le plan.

Les au moins deux articulations sont disposées symétriquement par rapport à un plan de symétrie de la partie mobile, ledit plan médian contenant la direction hors-plan.

Par exemple, le deuxième plan est du côté de la partie fixe et la deuxième partie comporte une face s'étendant dans le deuxième plan.

Le système peut comporter au moins quatre articulations de sorte que les axes des torsions des troisièmes parties des articulations soient disposés orthogonalement les uns par rapport aux autres.

Selon une caractéristique additionnelle, le système microélectromécanique comporte des moyens de mise en mouvement du deuxième élément au moins dans une direction hors-plan.

Le système microélectromécanique est par exemple un microphone.

### BRÈVE DESCRIPTION DES DESSINS

La présente invention sera mieux comprise sur la base de la description qui va suivre et des dessins en annexe sur lesquels:
- les figures 1A et 1B sont des vues de côté d'un système MEMS de l'état de la technique à l'état repos et dans un état où la masse s'est déplacée dans la direction hors-plan et illustrant l'allongement de l'articulation ;
- la figure 1C est une représentation graphique de l'allongement de l'articulation des figures 1A et 1B, dans la direction X en fonction du déplacement de la masse dans la direction Z ;
- la figure 2 est une vue en perspective d'un exemple d'articulation selon l'invention ;
- la figure 3 est une vue de détail de la figure 2 ;
- la figure 4 est une vue de dessus de l'articulation de la figure 2 ;
- la figure 5 est une vue en perspective d'un exemple de système M&NEMS comportant des articulations selon l'invention,
- la figure 6 est une vue de dessus d'un autre exemple de système M&NEMS comportant des articulations selon l'invention,
- la figure 7 est une vue de dessus d'un autre exemple de système comportant des articulations selon l'invention dans un état repos et dans un état de déplacement hors-plan ;
- la figure 8 est une vue de dessus d'un autre exemple de système comportant trois articulations selon l'invention,
- la figure 9 est une vue de dessus d'un autre exemple de système comportant quatre articulations selon l'invention,
- la figure 10 est une vue de dessus d'un autre exemple de réalisation d'une articulation dans lequel les troisième parties se déforment sensiblement uniquement en flexion.

### EXPOSÉ DÉTAILLÉ DE MODES DE RÉALISATION PARTICULIERS

Dans la présente demande, on désigne par « système microélectromécanique » ou « système MEMS » un système micro et/ou nanoélectromécanique, i.e. comportant des éléments ayant des dimensions micrométriques et/ou des éléments ayant des dimensions nanométriques.

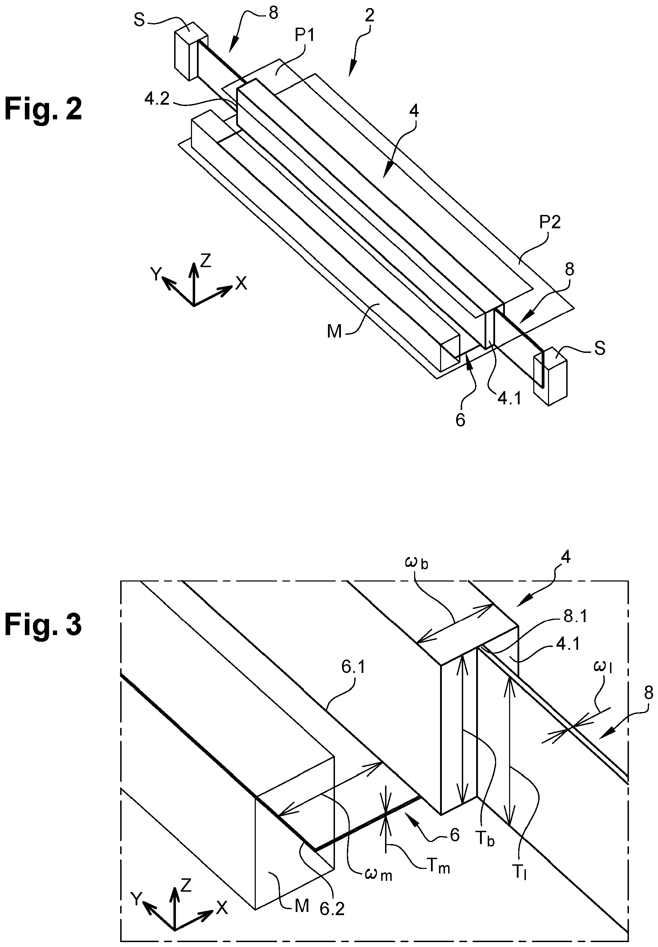

Sur les figures 2, 3 et 4, on peut voir un exemple d'une articulation 2 selon l'invention. En traits interrompus sont représentées une partie fixe ou substrat S d'un système microélectromécanique et une partie mobile ou masse M destinée à être suspendue au substrat S par l'articulation 2. Il sera compris que l'articulation peut réaliser l'articulation entre deux parties mobiles entre elles, et elles-mêmes mobiles par rapport à un substrat fixe.

L'articulation 2 est destinée à permettre un déplacement hors-plan de la partie mobile M.

Le plan du système est défini par les directions X et Y et correspond au plan moyen du système dans lequel s'étend la masse mobile M, c'est aussi le plan moyen de la partie fixe.

La direction hors-plan Z est orthogonale au plan du système.

L'articulation comporte une première partie rigide 4.

On entend par « partie ou élément rigide » un élément qui ne se déforme pas ou peu sous l'effet des contraintes généralement appliquées à un système MEMS dans le cas d'un capteur ou d'un actionneur dans un fonctionnement normal.

Dans l'exemple représenté la première partie 4 a la forme d'une poutre parallélépipédique présentant une épaisseur Tb, une largeur Wb et une longueur Lb. La première partie s'étend dans la direction Z entre un premier plan P1 et un deuxième plan P2 parallèles.

L'épaisseur Tb correspond à la dimension de la poutre selon la direction Z, la largeur Wb correspond à la dimension de la poutre selon la direction X et la longueur Lb correspond à la dimension de la poutre selon la direction Y.

Les dimensions Tb, Wb et Lb sont par exemple comprises entre quelques µm et quelques centaines de µm.

L'articulation 2 comporte une deuxième partie 6 présentant une épaisseur Tm faible par rapport à sa longueur Lm et à sa largeur Wm de sorte à permettre sa déformation en flexion selon la direction Z. Les rapports Tm/Wm et Tm/Lm sont par exemple compris entre 1/100 et 1/10.

Par exemple son épaisseur Tm est comprise entre une centaine de nm et quelques centaines de nm, sa longueur Lm et sa largeur Wm sont comprises entre quelques µm et quelques centaines de µm.

La deuxième partie 6 présente alors la forme d'une membrane qui est solidarisée à la première partie 4 par un premier bord 6.1 s'étendant selon la direction Y, et par un deuxième bord 6.2 parallèle au première bord 6.1 et destiné à être solidarisé à la masse M.

La membrane est disposée dans l'exemple représenté sur le plan P2 délimitant la face inférieure de la première partie dans l'exemple représenté. En outre, dans l'exemple représenté la face inférieure de la masse M est également contenue dans le plan P2.

En variante, la membrane pourrait être ancrée à la partie mobile dans toute position entre les plans P1 et P2.

L'articulation 2 comporte deux troisièmes parties 8 formant des lames et solidarisées par un bord 8.1 à une extrémité de la poutre 4.1, 4.2 le long de la direction Y. En outre les lames s'étendent dans le plan YZ.

Les lames sont dimensionnées pour pouvoir se déformer en flexion dans la direction X. Par exemple les lames présentent une épaisseur TI comprise entre 10 µm et quelques dizaines de µm, une largeur Wl comprise entre 100 nm et quelques micromètres et une longueur LI comprise entre quelques µm et quelques dizaines de µm.

Dans l'exemple représenté, les lames 8 s'étendent dans un plan R médian de la poutre parallèle au plan YZ.

Les lames 8 sont destinées à être ancrées sur la partie fixe S par un bord 8.2 parallèle au bord 8.1.

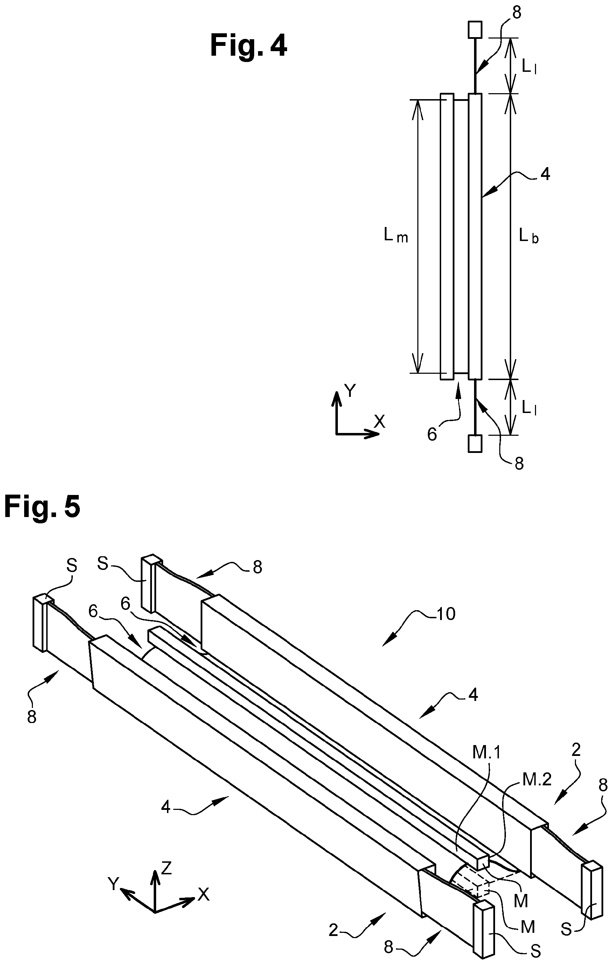

Sur la figure 5, on peut voir un système MEMS 10 mettant en œuvre deux articulations 2. Les articulations 2 sont ancrées sur la partie mobile M de manière symétrique par rapport à un plan de symétrie de la partie mobile M parallèle au plan YZ.

Les membranes 6 sont ancrées sur des faces parallèles M.1, M.2 de la partie mobile M.

Les lames sont ancrées sur la partie fixe S.

Dans la représentation de la figure 5, la partie mobile M a un mouvement hors-plan vers le haut, les membranes sont déformées en flexion et les lames 8 sont déformées en flexion dans la direction X. Les deux lames 8 vont également se déformer en torsion autour de l'axe Y, ce qui permet d'abaisser la raideur de l'articulation.

Le fonctionnement de l'articulation va maintenant être décrit en utilisant la figure 5.

Considérant l'application à un capteur, par exemple un accéléromètre destiné à mesurer l'accélération dans la direction Z.

Lorsque la partie mobile a un déplacement hors-plan sous l'effet d'une accélération selon Z, les deux membranes 6 sont déformées en flexion accompagnant le déplacement de la partie mobile selon Z, les lames 8 sont déformées en flexion le long de la direction X et également en torsion autour de l'axe Y.

Les déformations en flexion des lames 8 selon X permet aux poutres 4 de se déplacer dans la direction X, et aux bords des poutres 4, auxquels sont fixés les bords 6.1 des membranes, d'accompagner les membranes 6 dans leur déformation selon la direction X. Il en résulte une réduction de la variation de la rigidité de la structure, et donc une réduction du degré de non-linéarité. Les membranes sont principalement déformées dans la direction Z et ne sont plus étirées selon X. Grâce à l'invention, les articulations conservent un faible degré de non-linéarité même pour des déplacements selon Z de forte amplitude.

La partie mobile est guidée selon la direction Z.

Les articulations 2 présentent une grande rigidité selon la direction Y, la partie mobile est donc très bien maintenue dans la direction Y. En outre, les articulations 2 assurent également un maintien de la partie mobile M dans la direction X.

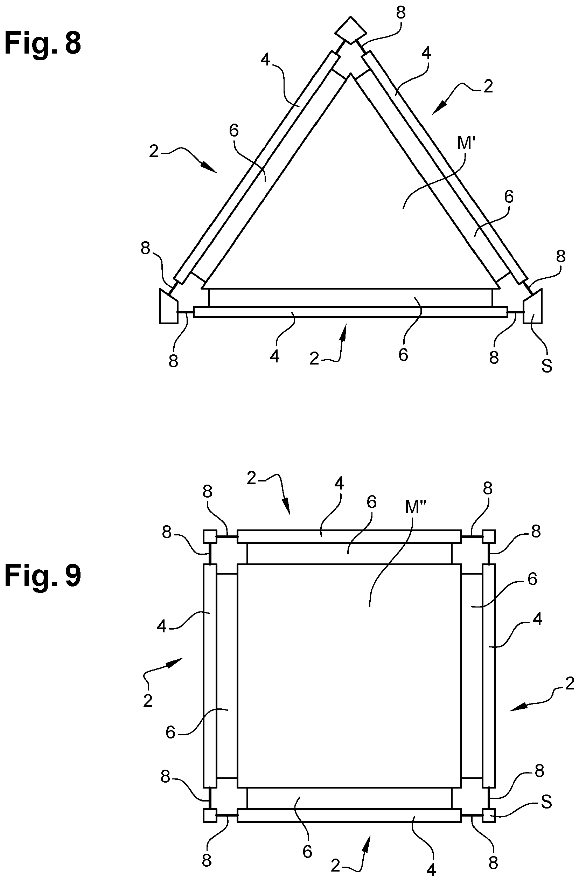

Afin d'améliorer le maintien dans la direction X, il est avantageux d'ajouter au moins une troisième articulation 2, les trois articulations 2 étant réparties à 120° les unes par rapport aux autres autour de la masse mobile M' comme cela est représenté schématique sur la figure 8.

Sur la figure 9, le système comporte quatre articulations 2 disposées à 90° les unes par rapport aux autres. Chaque articulation 2 est ancrée sur un bord de la masse mobile M".

Les configurations des systèmes des figures 8 et 9 assurent un très bon maintien des parties mobiles M dans le plan XY et leur guidage dans la direction Z.

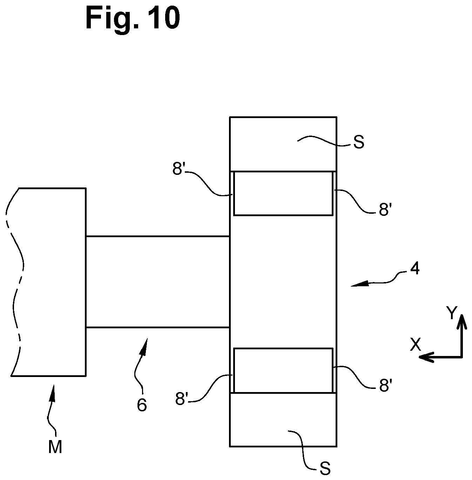

Sur la figure 10, on peut voir un autre exemple de réalisation d'une articulation, dans lequel les lames 8' se déforment quasiment uniquement en flexion dans la direction X.

Dans cet exemple l'articulation comporte une paire de lames 8' à chaque extrémité de la poutre 4.

Les lames 8' de chaque paire sont positionnées parallèlement l'une par rapport à l'autre dans le plan YZ. Dans cet exemple, une de leur face est alignée avec une face de la poutre parallèle au plan YZ. La mise en œuvre de deux lames 8' parallèles à chaque extrémité permet de bloquer la déformation en torsion de chacune des lames. Les deux lames 8' de chaque paire ont individuellement tendance à se déformer en torsion, mais en combinaison chaque lame 8' empêche la déformation en torsion de l'autre lame 8' lors du déplacement hors-plan de la partie mobile M. Les lames se déforment alors principalement en flexion et accompagnent le déplacement de la membrane 6 dans le plan. La rigidité non-linéaire de l'articulation est sensiblement réduite.

De préférence, les membranes sont structurées pour présenter des formes assurant une grande souplesse selon Z et une grande raideur dans le plan, par exemple elles comportent des croisillons ou treillis et/ou sont ajourées.

On constate donc que la rigidité de l'articulation dans les différentes directions est déterminée à la fois par les dimensions de la membrane et les dimensions des lames, ainsi il est possible d'ajuster finement ces rigidités en agissant sur les dimensions de la membrane et/ou sur les dimensions des lames. En augmentant l'épaisseur de la membrane et/ou la largeur des lames, la rigidité des articulations est augmentée, on peut également maîtriser le déplacement de la masse dans la direction Z.

L'articulation présente l'avantage d'offrir un très bon guidage selon Z tout en étant relativement compact du fait de sa faible épaisseur.

Il sera compris que les articulations peuvent être configurées pour permettre un déplacement souhaité selon la direction X. Dans ce cas, les lames peuvent être allongées dans la direction de la poutre et/ou rendues plus fines, offrant une certaine souplesse dans la direction X.

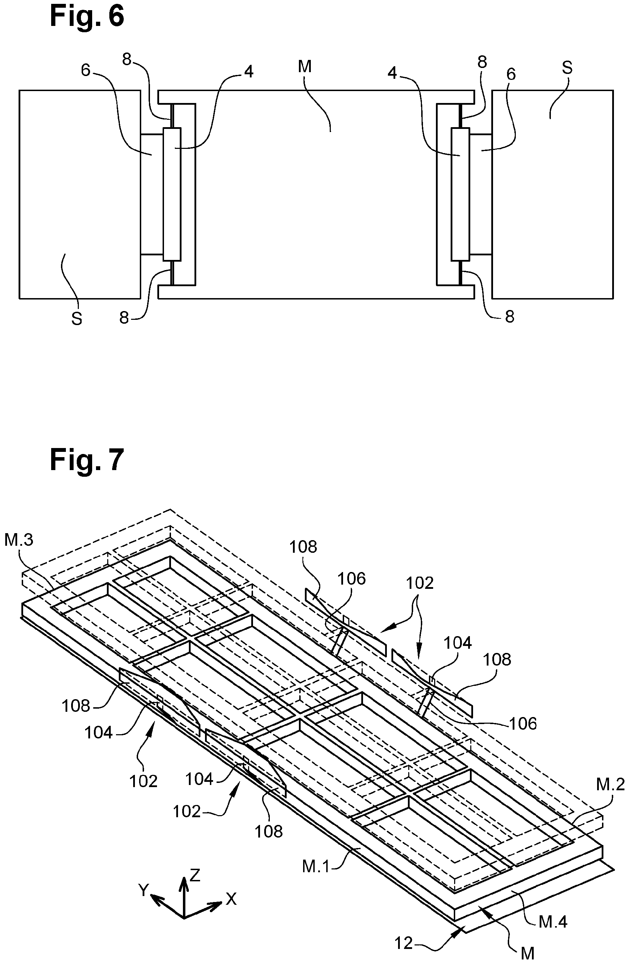

Sur la figure 6, on peut voir un autre exemple de système MEMS comportant deux articulations disposées symétriquement par rapport à la partie mobile M et dans lequel les lames 8 sont ancrées sur la partie mobile M et les membranes sont ancrées sur la partie fixe S.

Le fonctionnement est similaire à celui du système de la figure 5. On obtient un très bon maintien dans la direction Y et un guidage selon la direction Z avec un faible degré de non-linéarité.

Sur la figure 7, on peut voir un autre exemple de système MEMS comportant quatre articulations. Deux articulations 102 sont ancrées à un premier bord M.1 de la masse mobile M et deux articulations 102 sont ancrées à un deuxième bord M.2 de la masse mobile M parallèle au premier bord.

Dans cet exemple la longueur Lb de la première partie 104 est faible comparativement à la longueur Lm des lames 108. En outre les membranes 104 présentent une largeur Lm grande par rapport à leur longueur Lm.

A titre d'exemple, les articulations du système de la figure 7 peuvent présenter les dimensions suivantes :
Tm=1µm ; Lm = 10µm ; Wm = 35µm
Tb = 20µm ; Lb = 10µm ; Wb = 4µm
TI = 18µm ; LI = 84µm ; Wl = 1µm
Un jeu de quatre articulations présente une raideur de 80N/m

Sur la figure 7, on peut voir la partie mobile M à l'état repos, et dans une position hors-plan en cours de déplacement. Dans l'exemple représenté, le déplacement dans la direction Z est de l'ordre de 40 nm. Une telle structure permet un déplacement compris entre environ 100 nm et environ1 µm.

II sera compris que plus de deux articulations côte à côte peuvent être mises en œuvre.

En outre des nombres différents d'articulations ancrées aux bords de la partie mobile peuvent être mis en œuvre.

Par exemple, on peut prévoir dans le système de la figure 7 de mettre en œuvre une articulation sur le bord M.3 de la parie mobile et une articulation sur le bord M.4 de la partie mobile.

Les articulations des figures 5et 6 peuvent être combinées, par exemple la structure comporte une partie mobile suspendue par deux articulations selon l'invention, l'une est solidarisée à la partie mobile par sa deuxième partie (figure 5) et l'autre est solidarisée à sa partie mobile par ses troisièmes parties.

L'articulation selon l'invention peut être mise en œuvre dans des capteurs MEMS pour cela des moyens de détection du mouvement de la masse selon Z sont prévus, par exemple des moyens capacitifs ou des jauges de contraintes piézorésistives ou piézoélectriques.

L'articulation selon l'invention peut être mise en œuvre dans des actionneurs MEMS, pour cela des moyens d'actionnement 12 de la partie mobile dans la direction Z sont prévus, par exemple des moyens électrostatiques représentés schématiquement sur la figure 7. Les moyens électrostatiques comportent au moins une paire d'électrodes, l'une étant formée sur le substrat sous la partie mobile M et l'autre électrode étant formée sur la partie mobile M en regard de l'électrode sur le substrat S. L'application d'une différence de potentiels génère des forces électrostatiques entre les deux électrodes et donc un déplacement hors-plan de la masse mobile M par rapport au substrat S.

De manière très avantageuse, un système MEMS comportant les articulations selon l'invention peut être utilisé pour réaliser un microphone. Sur la figure 7, la partie mobile M peut former un piston pouvant se déplacer en Z sous l'effet d'un différentiel de pression entre ses deux faces, dû à une onde sonore

L'articulation et le système MEMS peuvent être avantageusement fabriqués par des procédés connus de la microélectronique par dépôt de couches et gravures. Par exemple les exemples de procédé de fabrication décrits dans le document FR2941533 peuvent être mis en œuvre pour réaliser un tel système MEMS.

Par exemple, les membranes sont formées par la couche supérieure d'un substrat silicium sur isolant ou SOI (Silicon on Insulator en terminologie anglo-saxonne) et la première partie et les lames sont réalisées par gravure et libération. En variante, les membranes sont réalisées par le dépôt d'une couche d'une épaisseur de quelques centaines de nm et la première partie et les lames sont réalisées par gravure et libération.

De manière très avantageuse, au moins la première partie et les troisièmes parties sont réalisées dans la même couche dans laquelle sont réalisées la partie mobile et une partie de la partie fixe.

Le système est par exemple réalisé en matériau semi-conducteur, tel que le silicium ou le SiGe.

## Revendications

1. Articulation entre au moins un premier élément (S) et au moins un deuxième élément (M) d'un système microélectromécanique, ledit premier élément (S) et ledit deuxième élément (M) étant mobiles l'un par rapport à l'autre au moins dans une direction hors-plan, ladite articulation comportant une première partie rigide (4), une deuxième partie (6) solidaire de la première partie (4) par une extrémité et destinée à être ancrée sur le premier élément, ladite deuxième partie (6) étant configurée pour être déformable en flexion dans une première direction (Z), et deux troisièmes parties (8) solidaires de la première partie (4) et destinées à être ancrées sur le deuxième élément, les troisièmes parties (8) étant configurées pour se déformer en flexion le long d'une deuxième direction (X) orthogonale à la première direction (Z).

2. Articulation selon la revendication 1, dans laquelle, dans un état non déformé, les troisièmes parties (8) s'étendent dans un plan orthogonal à un plan dans lequel s'étend la deuxième partie (6).

3. Articulation selon la revendication 1 ou 2, dans laquelle la deuxième partie (6) présente une dimension dans la première direction (Z) réduite par rapport aux dimensions dans les autres directions.

4. Articulation selon la revendication 1, 2 ou 3, dans laquelle la première partie (4) s'étend, dans la première direction (Z), entre un premier plan (P1) et un deuxième plan (P2) et dans lequel la deuxième partie (6) comporte une face située dans le premier plan (P1) ou le deuxième plan (P2).

5. Articulation selon l'une des revendications 1 à 4, dans laquelle les troisièmes parties (8) comportent au moins deux lames s'étendant sur une partie au moins de la dimension de la première partie (4) dans la première direction (Z).

6. Articulation selon la revendication 5, dans laquelle chaque troisième partie comporte une lame, la lame d'une troisième partie et la lame de l'autre troisième partie étant coplanaires et étant disposées de sorte à également se déformer en torsion, ou dans laquelle chaque troisième partie comporte deux lames, une lame de chaque troisième partie étant coplanaire avec une lame de l'autre troisième partie et dans laquelle les deux lames d'une troisième partie sont disposées l'une par rapport de sorte à ne pas ou peu se déformer en torsion.

7. Articulation selon l'une des revendications 1 à 6, dans laquelle les deuxièmes parties (6) comportent une structure en treillis de sorte à assurer une souplesse dans la première direction (Z) et une certaine rigidité dans au moins une troisième direction (Y) orthogonale aux première (Z) et deuxième (X) directions.

8. Articulation selon l'une des revendications précédentes, dans laquelle la deuxième partie (6) a une épaisseur (Tm) dans la première direction (Z) comprise entre une centaine de nm et quelques microns, une longueur (Lm) dans la troisième direction (Y) et une largeur (Wm) dans la deuxième direction (X) comprises entre quelques µm et quelques centaines de µm.

9. Articulation selon l'une des revendications précédentes, dans laquelle les troisième parties (8) ont une épaisseur (TI) dans la première direction (Z) comprise entre 10 µm et quelques dizaines de µm, une largeur (WI) dans la deuxième direction (X) du plan comprise entre 100 nm et quelques micromètres et une longueur (LI) dans la troisième direction (Y) comprise entre quelques µm et quelques dizaines de µm.

10. Articulation selon l'une des revendications précédentes, dans laquelle la première partie a une épaisseur (Tb) dans la première direction (Z), une longueur (Lb) dans la troisième direction (Y) et une largeur (Wb) dans la deuxième direction (X) comprises entre quelques µm et quelques centaines de µm.

11. Système microélectromécanique comportant au moins un premier élément (S) et au moins un deuxième élément (M) mobile l'un par rapport à l'autre au moins dans une direction hors-plan, et au moins deux articulations selon l'une des revendications 1 à 10, chacune ancrées au premier élément (S) et au deuxième élément (M), et dans lequel les articulations sont orientées de sorte que la première direction soit la direction hors-plan et les deuxième et troisième directions soient les directions dans le plan, les au moins deux articulations étant avantageusement disposées symétriquement par rapport à un plan de symétrie de la partie mobile (M), ledit plan médian contenant la direction hors-plan.

12. Système microélectromécanique selon la revendication 11 en combinaison avec la revendication 4, dans laquelle le deuxième plan (P2) est du côté de la partie fixe (S) et la deuxième partie (6) comporte une face s'étendant dans le deuxième plan (P2).

13. Système microélectromécanique selon la revendication 11 ou 12, comportant au moins quatre articulations de sorte que les axes des torsions des troisièmes parties des articulations soient disposés orthogonalement les uns par rapport aux autres.

14. Système microélectromécanique selon l'une des revendications 11 à 13, comportant des moyens (12) de mise en mouvement du deuxième élément (M) au moins dans une direction hors-plan.

15. Système microélectromécanique selon l'une des revendications 11 à 14, formant un microphone.

## Patentansprüche

1. Gelenk zwischen wenigstens einem ersten Element (S) und wenigstens einem zweiten Element (M) eines mikroelektromechanischen Systems, wobei das erste Element (S) und das zweite Element (M) wenigstens in einer Richtung außerhalb der Ebene relativ zueinander beweglich sind, wobei das Gelenk einen ersten starren Teil (4) und einen zweiten Teil (6) umfasst, der mit einem Ende fest mit dem ersten Teil (4) verbunden ist und dazu bestimmt ist, an dem ersten Element verankert zu werden, wobei der zweite Teil (6) derart ausgebildet ist, dass er durch Biegung in einer ersten Richtung (Z) verformbar ist, und zwei dritte Teile (8), die fest mit dem ersten Teil (4) verbunden sind und dazu bestimmt sind, an dem zweiten Element (M) verankert zu werden, wobei die dritten Teile (8) dazu ausgebildet sind, sich entlang einer zweiten Richtung (X) orthogonal zu der ersten Richtung (Z) durch Biegung zu verformen.

2. Gelenk nach Anspruch 1, wobei sich die dritten Teile (8) in einem nicht verformten Zustand in einer Ebene erstrecken, die orthogonal zu einer Ebene ist, in der sich der zweite Teil (6) erstreckt.

3. Gelenk nach Anspruch 1 oder 2, wobei der zweite Teil (6) in der ersten Richtung (Z) eine gegenüber den Abmessungen in den anderen Richtungen reduzierte Abmessung aufweist.

4. Gelenk nach Anspruch 1, 2 oder 3, wobei sich der erste Teil (4) in der ersten Richtung (Z) zwischen einer ersten Ebene (P1) und einer zweiten Ebene (P2) erstreckt und wobei der zweite Teil (6) eine Fläche aufweist, die in der ersten Ebene (P1) oder der zweiten Ebene (P2) liegt.

5. Gelenk nach einem der Ansprüche 1-4, wobei die dritten Teile (8) wenigstens zwei Lamellen umfassen, die sich über wenigstens einen Teil der Abmessung des ersten Teils (4) in der ersten Richtung (Z) erstrecken.

6. Gelenk nach Anspruch 5, wobei jeder dritte Teil eine Lamelle umfasst, wobei die Lamelle des einen dritten Teils und die Lamelle des anderen dritten Teils koplanar sind und dazu angeordnet sind, sich ebenfalls durch Torsion zu verformen, oder wobei jeder dritte Teil zwei Lamellen umfasst, wobei eine Lamelle jedes dritten Teils koplanar mit einer Lamelle des anderen dritten Teils ist und wobei die beiden Lamellen eines dritten Teils relativ zueinander derart angeordnet sind, dass sie eine geringe oder keine Verformung durch Torsion aufzuweisen.

7. Gelenk nach einem der Ansprüche 1 bis 6, wobei die beiden Teile (6) eine Gitterstruktur aufweisen, um eine Flexibilität in der ersten Richtung (Z) und eine gewisse Steifigkeit in wenigstens einer dritten Richtung (Y) orthogonal zur ersten (Z) und zweiten (X) Richtung zu gewährleisten.

8. Gelenk nach einem der vorhergehenden Ansprüche, wobei der zweite Teil (6) eine Dicke (Tm) in der ersten Richtung (Z) zwischen hundert nm und einigen Mikron, eine Länge (Lm) in der dritten Richtung (Y) und eine Breite (Wm) in der zweiten Richtung (X) zwischen einigen µm und einigen hundert µm aufweist.

9. Gelenk nach einem der vorhergehenden Ansprüche, wobei die dritten Teile (8) eine Dicke (TI) in der ersten Richtung (Z) zwischen 10 µm und einigen Dutzend µm, eine Breite (WI) in der zweiten Richtung (X) der Ebene zwischen 100 nm und einigen Mikrometern und eine Länge (LI) in der dritten Richtung (Y) zwischen einigen µm und einigen Dutzend µm aufweisen.

10. Gelenk nach einem der vorhergehenden Ansprüche, wobei der erste Teil eine Dicke (Tb) in der ersten Richtung (Z), eine Länge (Lb) in der dritten Richtung (Y) und eine Breite (Wb) in der zweiten Richtung (X) zwischen einigen µm und einigen hundert µm aufweist.

11. Mikroelektromechanisches System, umfassend wenigstens ein erstes Element (S) und wenigstens ein zweites Element (M), die wenigstens in einer Richtung außerhalb der Ebene relativ zueinander beweglich sind, und wenigstens zwei Gelenke nach einem der Ansprüche 1 bis 10, die jeweils an dem ersten Element (S) und dem zweiten Element (M) verankert sind, und wobei die Gelenke derart ausgerichtet sind, dass die erste Richtung die Richtung außerhalb der Ebene ist und die zweite und dritte Richtung die Richtungen innerhalb der Ebene sind, wobei die wenigstens zwei Gelenke vorteilhafterweise symmetrisch in Bezug auf eine Symmetrieebene des beweglichen Teils (M) angeordnet sind, wobei die Mittelebene die Richtung außerhalb der Ebene enthält.

12. Mikroelektromechanisches System nach Anspruch 11 in Verbindung mit Anspruch 4, wobei die zweite Ebene (P2) auf der Seite des festen Teils (S) liegt und der zweite Teil (6) eine Fläche aufweist, die sich in der zweiten Ebene (P2) erstreckt.

13. Mikroelektromechanisches System nach Anspruch 11, 12 oder 13, umfassend wenigstens vier Gelenke, so dass die Torsionsachsen der dritten Teile der Gelenke orthogonal zueinander angeordnet sind.

14. Mikroelektromechanisches System nach einem der Ansprüche 11 bis 13, umfassend Mittel (12), um das zweite Element (M) wenigstens in einer Richtung außerhalb der Ebene in Bewegung zu setzen.

15. Mikroelektromechanisches System nach einem der Ansprüche 11 bis 14, welches ein Mikrofon bildet.

## Claims

1. Hinge between at least one first element (S) and at least one second element (M) of a microelectromechanical system, said first element (S) and said second element (M) being able to move relative to each other at least in an out-of-plane direction, said hinge comprising a first rigid part (4), a second part (6) fixed to the first part (4) at one end and intended to be anchored on the first element, said second part (6) being configured to deform in bending in a first direction (Z), and two third parts (8) fixed to the first part (4) and intended to be anchored to the second element, the third parts (8) being configured to deform in bending along a second direction (X) orthogonal to the first direction (Z).

2. Hinge according to claim 1 wherein, in an undeformed state, the third parts (8) extend in a plane orthogonal to a plane in which the second part (6) extends.

3. Hinge according to claim 1 or 2, wherein a dimension of the second part (6) in the first direction (Z) is less than the dimensions in the other directions.

4. Hinge according to claim 1, 2 or 3, wherein the first part (4) extends in the first direction (Z) between a first plane (P1) and a second plane (P2) and wherein the second part (6) comprises a face located in the first plane (P1) or the second plane (P2).

5. Hinge according to any one of claims 1 to 4, wherein the third parts (8) comprise at least two blades extending over at least part of the dimension of the first part (4) in the first direction (Z).

6. Hinge according to claim 5, wherein each third part comprises a blade, the blade of a third part and the blade of the other third part being coplanar the two blades being coplanar and arranged so as to also deform in torsion or wherein each third part comprises two blades, one blade of each third part being coplanar with a blade of the other third part and wherein the two blades of a third part are arranged relative to each other so as to not deform in torsion, or to deform only slightly in torsion.

7. Hinge according to any one of claims 1 to 6, wherein the second parts (6) comprise a lattice structure to provide flexibility in the first direction (Z) and some stiffness in at least one third direction (Y) orthogonal to the first (Z) and second (X) directions.

8. Hinge according to any of the preceding claims, wherein the thickness (Tm) of the second part (6) in the first direction (Z) is between about a hundred nm and several microns, a length (Lm) in the third direction (Y) and a width (Wm) in the second direction (X) are between several µm and several hundred µm.

9. Hinge according to any of the preceding claims, wherein the thickness (TI) of the third parts (8) in the first direction (Z) is between about 10 µm and several tens of µm, its length (WI) in the second in-plane direction (X) is between 100 nm and several micrometres and its length (LI) in the third direction (Y) is between several µm and several tens of µm.

10. Hinge according to any of the preceding claims, wherein the thickness (Tb) of the first part in the first direction (Z), its length (Lb) in the third direction (Y) and its width (Wb) in the second direction (X) are between several µm and several hundred µm.

11. Microelectromechanical system comprising at least one first element (S) and at least one second element (M) able to move relative to each other in at least one out-of-plane direction, and at least two hinges according to one of claims 1 to 10, each anchored to the first element (S) and to the second element (M), and wherein the hinges are oriented such that the first direction is the out-of-plane direction and the second and third directions are in-plane directions, the at least two hinges are arranged symmetrically about a plane of symmetry of the moving part (M), said median plane containing the out-of-plane direction.

12. Microelectromechanical system according to claim 11 combined with claim 4, wherein the second plane (P2) is on the side of the fixed part (S) and the second part (6) comprises a face extending in the second plane (P2).

13. Microelectromechanical system according to claim 11 or 12, comprising at least four hinges such that the torsion axes of the third parts of the hinges are arranged orthogonal to each other.

14. Microelectromechanical system according to any one of claims 11 to 13, comprising means (12) of moving the second element (M) at least in an out-of-plane direction.

15. Microelectromechanical system according to any one of claims 11 to 14, forming a microphone
